# EUROPEAN PATENT SPECIFICATION

(11) **EP 3 106 888 B1**
(45) Date of publication and mention of the grant of the patent: **12.08.2020**
(21) Application number: 16173059.3
(22) Date of filing: 06.06.2016
(51) Int. Cl.: G01R 31/08

(54) **METHOD AND SYSTEM FOR PARTIAL DISCHARGE MEASUREMENT ON A POWER CABLE**
VERFAHREN UND SYSTEM ZUR TEILENTLADUNGSMESSUNG AN EINEM STROMKABEL
PROCÉDÉ ET SYSTÈME DE MESURE DE DÉCHARGE PARTIELLE SUR UN CÂBLE D'ALIMENTATION

(30) Priority: 15.06.2015 CH 8552015
(43) Date of publication of application: 21.12.2016
(73) Proprietor: Seitz Instruments AG, 5443 Niederrohrdorf (CH)
(72) Inventor: QUAK, Benjamin, 5443 Niederohrdorf (CH); SEITZ, Paul Peter, 5507 Mellingen (CH); WILD, Manuel, 70597 Stuttgart-Degerloch (DE); GULSKI, Edward, 8702 Zollikon (CH)
(74) Representative: Tompkin, Christine

(56) References cited:
- EP-A1- 1 892 534
- EP-A1- 2 863 553
- EP-A1- 2 866 041
- WO-A1-98/37427
- WO-A1-2011/109674

## Description

### Field of the invention

The invention relates to a method and system for partial discharge measurement on a power cable.

### Background art

Power cables are used to transport electric energy from one point to another. Low voltage, medium and high voltage cables and cable accessories are constructed having a conductive core and an outer insulation of solid, liquid and/or gaseous material. Most cables have a conductive outer screen or conductor. Testing of such cables and accessories may be performed during all phases of the component lifetime for purposes of quality control of the component itself, quality control of installation workmanship and for condition assessment. In general, such tests are performed at the specified nominal voltage as well as at elevated voltage levels. Such tests can be performed as a so-called voltage withstand test.

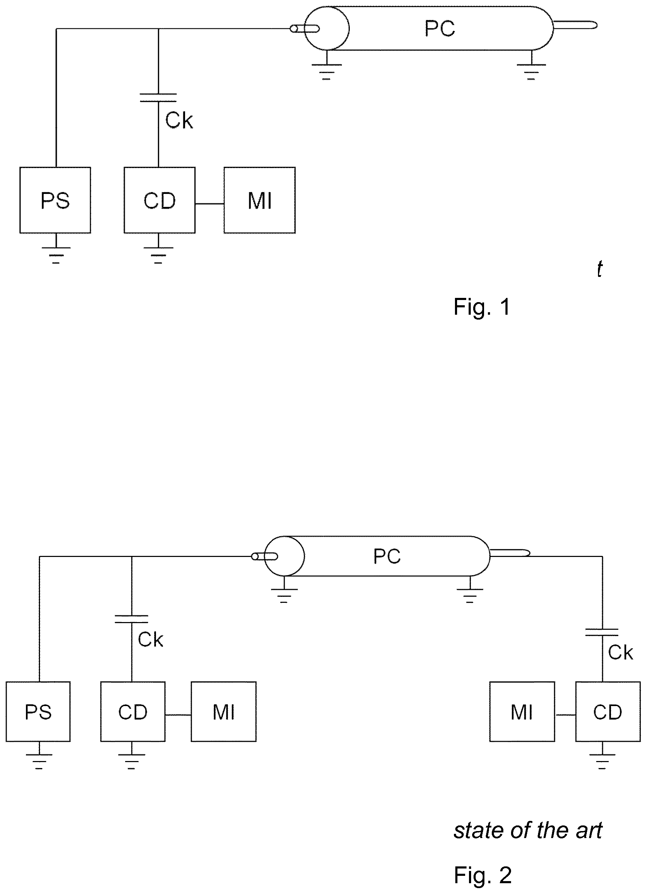

Traditional partial discharge (PD) measurements, also referred to as dielectric tests, are described for example in IEC 60270:2000 'High-voltage test techniques - Partial discharge measurements'. Those measurements are performed using a system as depicted schematically in figure 1. A power supply PS is used to energise the power cable PC to be tested by inputting a signal directly to the conducting part of the cable. In order to enable the measurement of a partial discharge on the cable, a coupling capacitor Ck with a coupling device CD provides a low-impedance path for pulses induced by a transfer of charge within a partial discharge PD, so that they can be measured by a measurement instrument MI. Additionally the MI can measure the transfer time or 'time of flight' of the induced pulses originating from the site of the partial discharge PD and travelling along the power cable in both directions from the PD site, where one set of pulses travel directly from the PD site to the MI and another set of pulses first travel to the end of the cable and reach the MI after reflection at that cable end. Using the data of the travel time the location of the PD site is calculated. Depending on the cable characteristics and environmental influences, this system may be used to test cables having a length of several kilometres.

In order to increase the sensitivity of the detection of partial discharges and thus also increase the maximum cable length for locating partial discharge sites, a further known system may be used as shown in figure 2. This system includes, in addition to the measurement system of figure 1 at the first, near end of the cable with the power supply, a second measurement setup connected to the second, far end of the cable, consisting of a coupling capacitor Ck, coupling device CD and measurement instrument MI. Operation of the measurement system in figure 2 requires either two measurement operators at the near and far end of the cable, or the setting up of a communication channel independent of the measurement system of figure 2, for example a dedicated optical fiber.

In known systems, such as described above, a high-voltage signal from the power supply is inputted directly into the conductor of the cable under test. In view of the high voltages involved, such systems place high demands on the communication transmission equipment to be connected to the cable under the test.

WO 2004/013642 proposes a method for testing cables for partial discharge by inputting at a first position a current pulse to the cable via the conductive earth sheath of the cable, rather than directly to the main conductive part of the cable, and producing a voltage pulse over the dielectric between the conductor and the earth sheath. The voltage pulse displaces to a second position, where the signal is detected. There is no direct contact between the high voltage-carrying part of the cable and the parts inputting the test signal, so that the conductors of the cable need not be disconnected from the voltage in order to perform the test.

EP 2 437 075 discloses a further system using a measuring unit connected to the earth sheath of a power cable and requiring only one operator. Similarly as in other known systems, this system measures two partial discharge signals, one originating directly from the partial discharge site and a second signal reflected off a passive unit connected to the ground cable connected to the conductive earth sheath at the end of the cable. Such passive unit is for example an element having low magnetic impedance such as a ferrite. Detection of both signals and measurement of the time difference of their arrival allows calculation of the location of the partial discharge on the cable.

EP 2 866041 and EP 2 863 553 disclose a method of surveilling a power cable, taking measurements continuously using the normal mains transmitted by the cable during normal operation of the power cable. A parasitic interfering signal, which is on top of the normal mains signal, is used for the measurement of a partial discharge. A circuitry to measure partial discharge signals comprises a coupling capacitor to which two coupling circuitries are connected in parallel. A modem is connected to the first coupling circuitries, and a detector circuitry 3 to the second coupling circuitry. Measurement signals are transmitted via a separate designated cable to a central server for further processing.

WO 2011/109674 discloses a partial discharge measurement using a part of a communication system to measure the partial discharge. The measurement results are communicated to a central point or monitoring station.

### Summary of the invention

It is the object of the present invention to provide a method and system for testing a power cable for transport of electrical energy, in particular at voltages above 400 V, and detecting a partial discharge in the power cable, where such method and system enables easier and simplified execution of PD detection compared to testing methods and systems of the state of the art.

A method for PD measurement on electric power cable according to the invention and disclosed in claim 1 comprises
- connecting a high-voltage power supply to a high-voltage conductor of the power cable to be tested at a first of two selected measurement locations on the power cable,
   - connecting at each of two measurement locations along a power cable a capacitor to a high-voltage conductor of the power cable,
   - connecting to the low-voltage end of each capacitor a communication coupling device and a measurement coupling device,), where the communication coupling device (CCD) and the measurement coupling device (CD) are connected in series,
   - connecting at each measurement location a communication system (CS) to the communication coupling device (CCD) and connecting a measurement instrument (MI) to the measurement coupling device (CD),
   - providing high-voltage signals to a high-voltage carrying conductor of the power cable to be tested by means of the high-voltage power supply (PS),,
   - receiving a partial discharge signal at each of the two measurement locations by means of the measurement instruments and generating measurement results of the partial discharge at each measurement location,
   - transmitting measurement results of the partial discharge from one measurement location via the high-voltage conductor of the cable to the other measurement location,
   - receiving the transmitted measurement results at the other measurement location and calculating the location of the partial discharge using the measurement results from both measurement locations.
The method according to the invention allows execution of the PD measurement of a power cable along a section defined by two selected measurement locations by one operator alone. The operator connects a high-voltage power supply to a high-voltage conductor of the cable to be tested at the first selected measurement location. A capacitor is connected to the conductor of the power cable at the first and second measurement location, and a communication coupling device, a measurement coupling device in the form of an impedance element, and a communication system and a signal measurement instrument are connected to the low-voltage end of the capacitor. The operator then executes the method at the first location. During the test signals are provided by means of the power supply directly to the conductor of the cable, and partial discharge signals are transmitted via the conductor to both measurement instruments. The discharge signal received at the second location is measured by the measurement system and measurement results of the partial discharge signal are transmitted by means of the communication system via the high-voltage conductor of the cable to the first location, where it is received by its measurement instrument. Using measured values from both partial discharge signals, such as time-of flight data and/or amplitude data, the location of the partial discharge can be determined. Measurement parameters for both measurement instruments can be adjusted by the operator at the first location by communicating with the measurement instrument at the other measurement location via the conductor of the cable itself.
Setting up the measurement system can be done in several different orders of connecting the elements. For example, elements could be connected previous to the connection to the power cable.

The method utilizes the high-voltage conductor of the power cable itself for the transmittal of the measurement results of partial discharge signals as well for the control of the measurement instrument at another measurement location far away along the cable. The operator can input measurement parameters, for example by means of a user interface installed at the measurement location with the power supply, and transmit the parameters via the conductor of the cable to the measurement instrument at the other location. Similarly, partial discharge measurement results generated at the other measurement location as well as control signals of the measurement instrument are transmitted via the conductor of the cable and received at the first location operated by the operator.

The measured and calculated data can be displayed and analysed on a user interface.

Unlike the method disclosed in WO 2004/013642, where test signals are injected to the earth screens of the power cable, the method according to the invention injects test signals directly into the conductor(s) of the power cable. In addition, the method according to the invention uses the high-voltage conductors for the communication between the measurement locations. When the power cable under test is energized with high voltage, the communication path needs some means of isolation from the high voltage path. In order to provide for this isolation, a capacitive coupling is used, where the communication system with communication coupling device are arranged at the low-voltage end of the capacitor, the capacitor being arranged between the high-voltage conductor of the power cable and the communication system with communication coupling device. Because the capacitor is used for the communication as well as for the PD measurement, no further large high-voltage capacitor is necessary.

In an embodiment of the method, the PD measurement method is performed by inputting measurement parameters via a user interface. Thereby, the operator can control the PD measurement and for example adjust the sensitivity of the measurement instrument by means of the interface. Alternatively, measurement parameters and control signals can be input by means of an automated measurement and controlling device having appropriate software.

In a further embodiment of the method, the method is used for the PD measurement of a branched power cable system, where capacitor, communication coupling device, communication system, measurement coupling device and measurement instruments are connected to the conductor of the cable at more than two measurement locations, for example at three or more measurement locations, and partial discharge signals are transmitted from two or more measurement locations to the measurement location with the power supply.

In a further embodiment of the method, the method is used for the PD measurement of a power cable having connecting joints, where the capacitor and the further elements as described above are connected to the conductor of the cable at one or both ends of the cable and as well as to capacitive or inductive sensors connected to one or more joints at the several connecting joint locations.

A system according to the invention for PD measurement on a power cable according to claim 1 is disclosed in claim 7.

The system comprises
- a high-voltage power supply connectable to a high-voltage conductor of the power cable ,
- two test modules configured for connection to the high-voltage conductor of the power cable at two selected measurement points on the power cable,
   each test module containing:
   - a high-voltage capacitor, connectable to the high-voltage conductor of the power cable at the two measurement points on the power cable,
   - a communication coupling device connected to the low-voltage end of the capacitor and
   - a measurement coupling device connected to the communication coupling device and
   - a measurement instrument connected to the measurement coupling device and
   - a communication system connected to the communication coupling device and the measurement instrument.

A further system according to the invention for PD measurement on a power cable according to claim 1 is disclosed in claim 8.

The system comprises
- a high-voltage power supply connectable to a high-voltage conductor of the power cable,
- two test modules configured for connection to the high-voltage conductor of the power cable at two selected measurement points on the power cable,
   each test module containing:
   - a high-voltage capacitor, connectable to the high-voltage conductor of the power cable at the two measurement points on the power cable,
   - a measurement coupling device connected to the low-voltage end of the capacitor and
   - a communication coupling device connected to the measurement coupling device and
   - a measurement instrument connected to the measurement coupling device and
   - a communication system connected to the communication coupling device and the measurement instrument.

In a first embodiment of the invention each communication coupling device is placed between the capacitor and the measurement coupling device.
In a second embodiment of the invention each measurement coupling device is placed between the capacitor and the communication coupling device.

In a particular embodiment of the invention the communication coupling device is realized by a galvanic, inductive or resonant coupling.
The system according to the invention does not require any additional large equipment for isolating the communication coupling device from the high voltage. As such, it may be realized in a small volume and having low weight, so that it can easily be placed in a housing to be handled and transported by one person. Consisting of a single device for each location, the testing system is easy to set up and use as only the test object connections need to be made at each location in order to enable communication between the measurement instruments at the measurement locations and no other connections between the device and the test object, the power cable, are necessary.

The PD measuring system according to the invention can be used together with a power supply in order to provide the test signal to the conductor of the power cable. The power supply can be any power supply suitable to provide test signals.

A further embodiment of the system according to the invention comprises more than two capacitors, each connectable to several measurement locations along power cable or branched power cable systems, and more than two communication coupling devices, measurement coupling devices, communication systems and measurement instruments, each connected to the low-voltage end of a capacitor. The system and method according to the invention are particularly suited for PD measurement on power cables transporting power at 400 V and above.
The invention will be described in greater detail, by way of example, with reference to figures as follows.

### Brief description of the figures

- Fig. 1: shows a system of the state of the art for detecting a partial discharge in a cable.
- Fig. 2: shows a further system of the state of the art for detecting a partial discharge in a cable.
- Fig. 3a: shows a first exemplary embodiment of a system according to the present invention for detecting a partial discharge in a cable.
- Fig. 3b: shows a second exemplary embodiment of a system according to the present invention for detecting a partial discharge in a cable.
- Fig. 4a: shows the schematic of the communication coupling device CCD applicable to the detail IVa in figure 3a.
- Fig. 4b: shows the schematic of the communication coupling device CCD applicable to the detail IVb in figure 3b.
- Fig. 5a-d: each show an exemplary embodiment of the communication coupling device CCD as it may be applied to the system in fig. 3a and 3b and according to the schematic of fig. 4a and 4b, respectively.

### Embodiments of the invention

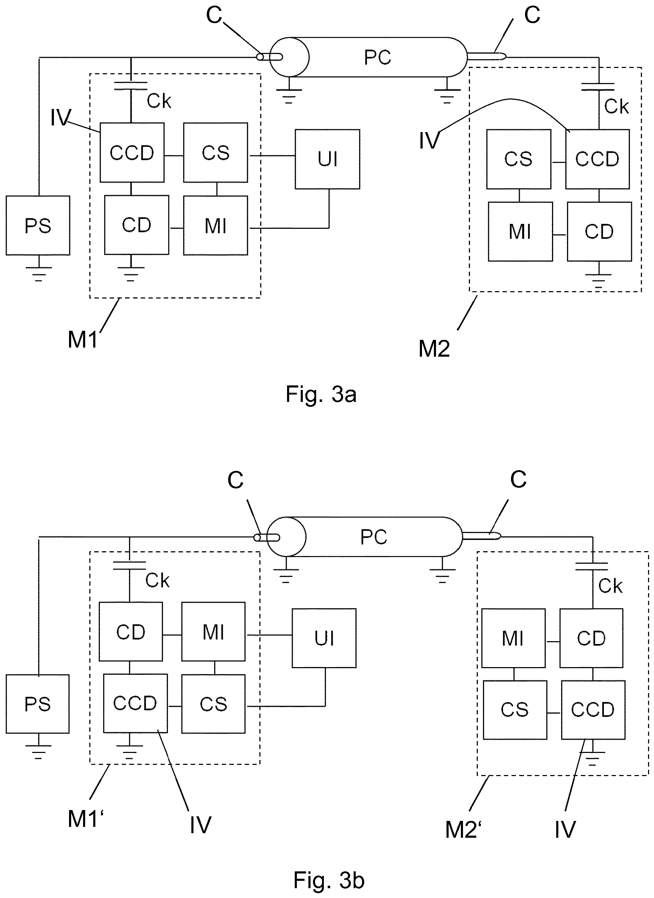

Figure 3a and b show first and second embodiments of the system according to the invention respectively as it may be used to perform the testing method as disclosed herein. Each enables the testing method with same functionality.

The exemplary system in figure 3a, b for testing power cables for partial discharge essentially contains at least two identical test modules M1, M2, each containing a high-voltage capacitor Ck, a communication coupling device CCD, a coupling system CS, a measurement coupling device CD and measurement instrument MI. Each module M1, M2 is configured for connection to the high-voltage conductor C of a power cable PC at two different measurement locations typically separated by a long distance of up to tens of kilometers, wherein it is the capacitor Ck, which is at one end directly connectable to the high-voltage conductor C of the cable PC. The capacitor Ck is therefore connectable at its high-voltage end to the power-cable, while all other elements of the module are arranged at the other, low-voltage end of the capacitor Ck. That is, the capacitors Ck are arranged between connectors to the power cable and the other elements of each module M1, M2.

In further exemplary systems the modules M1, M2 are not necessarily identical. They can be different from each other, for example by the use of configurations of the communication coupling device.

The capacitive coupling by means of the specific arrangement of the capacitor Ck allows both arrangements of the elements of the modules M1, M2, M1', M2' as depicted in figures 3a and 3b. Both arrangements allow the isolation of the communication system CS from the high voltage. The modules M1, M2, in Figure 3a differ from the modules M1', M2' in figure 3b in the relative location of the communication coupling device CCD and the measurement coupling device CD.

When in operation, the system is used with a power supply PS, which is set up to provide high-voltage test signals to the high-voltage conductor C of the power cable PC at the first measurement location selected by the user, who operates the module M1. The capacitor Ck of the first test module M1 is connected to the power cable at this location, and the capacitor Ck of a second test module M2 is connected to the power cable at a second selected location. The test measurement may be executed by means of a user interface UI or by means of a control device attachable to the first module M1. Measurement parameters may be input by this way to the measurement instrument MI and transmitted by means of the communication system CS and communication coupling device and via the high-voltage conductor C to the second module M2, where it is received by the measurement instrument M2 via the communication coupling device CCD and the communication systems CS.

The measurement coupling device CD is realized for example by an impedance element such as a transformer or a resistor.

The communication system CS is realized by a transmitter/receiver for example a modem.

When the power supply PS is turned on, test signals are applied to the high-voltage conductor C, and a partial discharge site causes signals to travel from that site in both directions to the modules M1, M2. Using a system as shown in figure 3a, the discharge signal arriving at module M2 is directed by the coupling communication device CCD and the measurement coupling device CD to the measurement instrument MI, which measures the discharge signal and generates measurement results of the partial discharge. The measurement results are transmitted from the measurement instrument MI via the communication system CS and the communication coupling device CCD through the conductor C to the module M1, where it is received by the measurement instrument MI via the communication coupling device CCD. Calculated data of the partial discharge is transmitted to the user interface UI.

When using a system as shown in figure 3b, the transmittal of the partial discharge signal and measurement results occurs in principle in the same manner. With module M2' the partial discharge signal is received by the measurement instrument MI via the measurement communication device CD and measurement results generated by the measurement instrument MI are transmitted via the communication system CS and the communication coupling device CCD to the conductor C of the power cable PC. At module M1' the measurement instrument MI receives the transmitted measurement signals via the measurement communication device CD. The partial discharge location is then calculated and transmitted to the user interface UI.

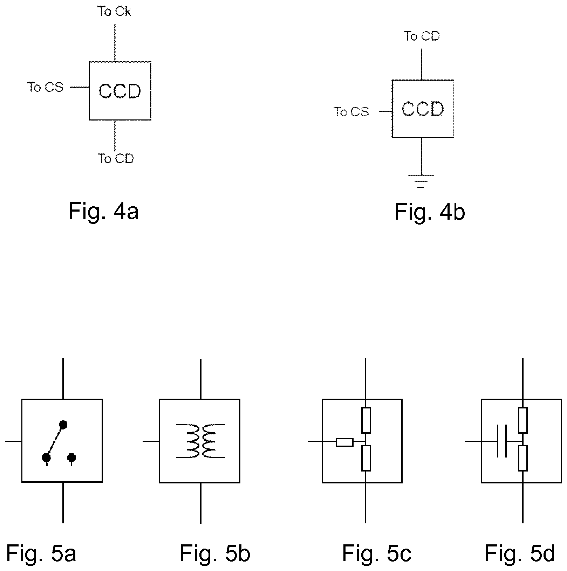

The communication coupling device CCD is realized by various implementations as depicted in figure 5a,b,c,d. The most straightforward implementation is a simple switchover as shown in figure 5a that divides communication signals and measurement signals in the time domain.

Another implementation is an inductive coupling by means of a transformer, as shown in figure 5b, which separates the communication signals and measurement signals in the time domain, or in the frequency domain, when measurement frequency band and the communication band are set not to overlap.

Capacitive coupling as shown in figure 5d can also be used to inject communication signals into Ck, which also separates the communication signals and measurement signals in the time domain, or in the frequency domain, when measurement frequency band and the communication band are set not to overlap.

Furthermore, the communication coupling device can be realized by a direct galvanic connection such as in figure 5c, provided that both the communication system CS and the measurement coupling device CD can withstand each other's signal levels, which also separates the communication signals and measurement signals in the time domain, or in the frequency domain, when measurement frequency band and the communication band are set not to overlap.

In a variant of the system according to the invention, the system realized with a galvanic or inductive coupling is used on one more unused phases of a power cable during the test. This coupling comprises a direct, galvanic connection of the communication coupling device CCD to the power cable. In order to meet safety grounding earthing demands, the communication coupling device CCD can comprise a transformer such that the unused phase is grounded for power frequencies and DC at all times, while the communications signals can still couple in to the cable.

In a further particular embodiment of the system according to the invention the communication coupling device CCD is connected to an inductor Lr arranged between the communication system CS and the communication coupling device CCD of the modules M1 and M2 in figure 3a providing a resonant coupling, which constitutes an extension of the capacitive coupling described above, by means of decreasing the losses due to the capacitor Ck. The inductor Lr provides a series resonant circuit comprising the capacitor Ck and the inductor Lr. This reduces losses for transmitting and receiving signals normally incurred by the use of a coupling capacitor alone.

The system as described may also be used for PD measurements on branched power cable circuits by applying it in analogous manner as described above by simply connecting additional measurement modules M2 to the conductor of the power cable at the end of each branch to be tested.

Furthermore, the PD measurement method may be applied at connection joints along a power cable, in order to increase the measurement sensitivity in detecting partial discharge. In this case, a current transformer or capacitive coupler is used to measure the partial discharge in combination with a measurement instrument MI. These connection joints can then also be used for coupling communication signals into and out of the power cable. By this way, the data received at the measurement instruments at all the connection joints can be received at the measurement module M1 at the first measurement location and the measurement instruments at all connection joints can be controlled by one operator operating the module M1.

Other than the partial discharge measurement, other measurements such as dissipation factor and leakage current measurements can be performed at the same time.

### Terms used in figures

- PC: power cable
- MI: measurement instrument
- CD: measurement coupling device
- PS: power supply
- Ck: high voltage coupling capacitor
- CD: measurement coupling device
- CCD: communication coupling device
- CS: communication system
- UI: User interface
- C: high/voltage conductor of power cable

## Claims

1. A method for partial discharge measurement on an electric power cable (PC) comprising:
- connecting a high-voltage power supply (PS) to a high-voltage conductor of the power cable (PC) to be tested at a first of two selected measurement locations on the power cable (PC),connecting at each of the two measurement locations along the power cable (PC) a capacitor (Ck) to a high-voltage conductor (C) of the power cable (PC), **characterized by**
- connecting to the low-voltage end of each capacitor (Ck) a communication coupling device (CCD) and a measurement coupling device (CD), where the communication coupling device (CCD) and the measurement coupling device (CD) are connected in series,
- connecting at each measurement location a communication system (CS) to the communication coupling device (CCD) and connecting a measurement instrument (MI) to the measurement coupling device (CD),
- providing high-voltage signals to the high-voltage carrying conductor (C) of the power cable (PC) by means of the high-voltage power supply (PS),
- receiving a partial discharge signal at each of the two measurement locations by means of the measurement instruments (MI) and generating measurement results of the partial discharge at each measurement location,
- transmitting measurement results of a partial discharge from one measurement location via the high-voltage conductor (C) of the cable (PC) to the other measurement location,
- receiving the transmitted measurement results of a partial discharge at the other measurement location.

2. Method according to claim 1 **characterized by**
- calculating the location of the partial discharge using the measurement results from both measurement locations.

3. Method according to claim 1 **characterized by**
inputting measurement parameters via a user interface (Ul) connected to the communication system (CS).

4. Method according to claim 1 **characterized by**
inputting measurement parameters via an automated measurement and controlling device connected to the communication system (CS).

5. Use of the method according to one of the claims 1 to 4 for partial discharge measurement on a branched power cable system, where a capacitor (Ck), communication coupling device (CCD), communication system (CS) and measurement instruments (MI) are connected to the conductor of the cable at more than two measurement locations.

6. Use of the method according to one of the claims 1 to 4 for the testing of a power cable having connecting joints, where the capacitor (Ck), communication coupling devices (CCD), communication system (CS), measurement coupling device (CD) and measurement instruments (MI) are connected to the cable at several connecting joint locations.

7. System configured to perform the method of claim 1 for testing an electric power cable (PC) comprising
- a high-voltage power supply (PS) connectable to a high-voltage conductor (C) of the power cable (PC),
- two test modules (M1, M2) configured for connection to the high-voltage conductor (C) of the power cable (PC) at two selected measurement points on the power cable (PC),
each test module (M1, M2) containing:
- a high-voltage capacitor (Ck), connectable to the high-voltage conductor (C) of the power cable (PC) at the two measurement points on the power cable (PC),
**characterized by**
- a communication coupling device (CCD) connected to the low-voltage end of the capacitor (Ck) and
- a measurement coupling device (CD) connected to the communication coupling device (CCD) and
- a measurement instrument (MI) connected to the measurement coupling device (CD) and
- a communication system (CS) connected to the communication coupling device (CCD) and the measurement instrument (MI).

8. System configured to perform the method of claim 1 for testing an electric power cable (PC) comprising
- a high-voltage power supply (PS) connectable to a high-voltage conductor (C) of the power cable (PC),
- two test modules (M1', M2') configured for connection to the high-voltage conductor (C) of the power cable (PC) at two selected measurement points on the power cable (PC),
each test module (M1', M2') containing:
- a high-voltage capacitor (Ck), connectable to the high-voltage conductor (C) of the power cable (PC) at the two measurement points on the power cable (PC),
**characterized by**
- a measurement coupling device (CD) connected to the low-voltage end of the capacitor (Ck) and
- a communication coupling device (CCD) connected to the measurement coupling device (CD) and
- a measurement instrument (MI) connected to the measurement coupling device (CD) and
- a communication system (CS) connected to the communication coupling device (CCD) and the measurement instrument (MI).

9. System according to claim 7 or 8 **characterized in that** the communication coupling device (CCD) is realized by a galvanic, inductive or capacitive coupling or by a switch.

10. System according to claim 7 or 8 **characterized in that** the communication coupling device (CCD) comprises a switch, a transformer, a resistor, or a capacitor.

11. System according to one of the claims 7 to 10 **characterized in that** an inductor (Lr) is arranged between the communication coupling device (CCD) and the communication system (CS).

## Patentansprüche

1. Verfahren zur Teilentladungsmessung an einem elektrischen Stromkabel (PC), umfassend:
- das Verbinden einer Hochspannungsstromversorgung (PS) mit einem Hochspannungsleiter des zu prüfenden Stromkabels (PC) an einer ersten von zwei ausgewählten Messstellen an dem Stromkabel (PC), das Verbinden eines Kondensators (Ck) an jeder der zwei Messstellen entlang des Stromkabels (PC) mit einem Hochspannungsleiter (C) des Stromkabels (PC),
**gekennzeichnet durch**
- das Verbinden einer Kommunikationskopplungsvorrichtung (CCD) und einer Messkopplungsvorrichtung (CD) mit dem Niederspannungsende jedes Kondensators (Ck), wobei die Kommunikationskopplungsvorrichtung (CCD) und die Messkopplungsvorrichtung (CD) in Reihe verbunden sind,
- das Verbinden, an jeder Messstelle, eines Kommunikationssystems (CS) mit der Kommunikationskopplungsvorrichtung (CCD) und das Verbinden eines Messinstruments (MI) mit der Messkopplungsvorrichtung (CD),
- das Bereitstellen von Hochspannungssignalen an den hochspannungsführenden Leiter (C) des Stromkabels (PC) mithilfe der Hochspannungsstromversorgung (PS),
- das Empfangen eines Teilentladungssignals an jeder der zwei Messstellen mithilfe der Messinstrumente (MI) und das Generieren von Messergebnissen der Teilentladung an jeder Messstelle,
- das Senden von Messergebnissen einer Teilentladung von einer Messstelle über den Hochspannungsleiter (C) des Kabels (PC) zu der anderen Messstelle,
- das Empfangen der gesendeten Messergebnisse einer Teilentladung an der anderen Messstelle.

2. Verfahren nach Anspruch 1, **gekennzeichnet durch**
- das Berechnen der Stelle der Teilentladung unter Verwendung der Messergebnisse von beiden Messstellen.

3. Verfahren nach Anspruch 1, **gekennzeichnet durch**
das Eingeben von Messparametern über eine Benutzerschnittstelle (UI), die mit dem Kommunikationssystem (CS) verbunden ist.

4. Verfahren nach Anspruch 1, **gekennzeichnet durch**
das Eingeben von Messparametern über eine automatisierte Mess- und Steuerungsvorrichtung, die mit dem Kommunikationssystem (CS) verbunden ist.

5. Verwendung des Verfahrens nach einem der Ansprüche 1 bis 4 zur Teilentladungsmessung an einem verzweigten Stromkabelsystem, wobei ein Kondensator (Ck), eine Kommunikationskopplungsvorrichtung (CCD), ein Kommunikationssystem (CS) und Messinstrumente (MI) an mehr als zwei Messstellen mit dem Leiter des Kabels verbunden sind.

6. Verwendung des Verfahrens nach einem der Ansprüche 1 bis 4 zum Prüfen eines Stromkabels mit Verbindungsfugen, wobei der Kondensator (Ck), die Kommunikationskopplungsvorrichtungen (CCD), das Kommunikationssystem (CS), die Messkopplungsvorrichtung (CD) und die Messinstrumente (MI) an mehreren Verbindungsfugenstellen mit dem Kabel verbunden sind.

7. System, das dafür ausgelegt ist, das Verfahren nach Anspruch 1 zum Prüfen eines elektrischen Stromkabels (PC) auszuführen, umfassend:
- eine Hochspannungsstromversorgung (PS), die mit einem Hochspannungsleiter (C) des Stromkabels (PC) verbindbar ist,
- zwei Testmodule (M1, M2), die zur Verbindung mit dem Hochspannungsleiter (C) des Stromkabels (PC) an zwei ausgewählten Messpunkten an dem Stromkabel (PC) ausgelegt sind,
wobei jedes Testmodul (M1, M2) Folgendes enthält:
- einen Hochspannungskondensator (Ck), der an den zwei Messpunkten an dem Stromkabel (PC) mit dem Hochspannungsleiter (C) des Stromkabels (PC) verbindbar ist,
**gekennzeichnet durch**
- eine Kommunikationskopplungsvorrichtung (CCD), die mit dem Niederspannungsende des Kondensators (Ck) verbunden ist, und
- eine Messkopplungsvorrichtung (CD), die mit der Kommunikationskopplungsvorrichtung (CCD) verbunden ist, und
- ein Messinstrument (MI), das mit der Messkopplungsvorrichtung (CD) verbunden ist, und
- ein Kommunikationssystem (CS), das mit der Kommunikationskopplungsvorrichtung (CCD) und dem Messinstrument (MI) verbunden ist.

8. System, das dafür ausgelegt ist, das Verfahren nach Anspruch 1 zum Prüfen eines elektrischen Stromkabels (PC) auszuführen, umfassend:
- eine Hochspannungsstromversorgung (PS), die mit einem Hochspannungsleiter (C) des Stromkabels (PC) verbindbar ist,
- zwei Testmodule (M1', M2'), die zur Verbindung mit dem Hochspannungsleiter (C) des Stromkabels (PC) an zwei ausgewählten Messpunkten an dem Stromkabel (PC) ausgelegt sind,
wobei jedes Testmodul (M1, M2) Folgendes enthält:
- einen Hochspannungskondensator (Ck), der an den zwei Messpunkten an dem Stromkabel (PC) mit dem Hochspannungsleiter (C) des Stromkabels (PC) verbindbar ist,
**gekennzeichnet durch**
- eine Messkopplungsvorrichtung (CD), die mit dem Niederspannungsende des Kondensators (Ck) verbunden ist, und
- eine Kommunikationskopplungsvorrichtung (CCD), die mit der Messkopplungsvorrichtung (CD) verbunden ist, und
- ein Messinstrument (MI), das mit der Messkopplungsvorrichtung (CD) verbunden ist, und
- ein Kommunikationssystem (CS), das mit der Kommunikationskopplungsvorrichtung (CCD) und dem Messinstrument (MI) verbunden ist.

9. System nach Anspruch 7 oder 8, **dadurch gekennzeichnet, dass** die Kommunikationskopplungsvorrichtung (CCD) durch eine galvanische, induktive oder kapazitive Kopplung oder durch einen Schalter ausgebildet ist.

10. System nach Anspruch 7 oder 8, **dadurch gekennzeichnet, dass** die Kommunikationskopplungsvorrichtung (CCD) einen Schalter, einen Transformator, einen Widerstand oder einen Kondensator umfasst.

11. System nach einem der Ansprüche 7 bis 10, **dadurch gekennzeichnet, dass** ein Induktor (Lr) zwischen der Kommunikationskopplungsvorrichtung (CCD) und dem Kommunikationssystem (CS) angeordnet ist.

## Revendications

1. Procédé de mesure de décharge partielle sur un câble d'alimentation électrique (PC) comprenant :
- la connexion d'un bloc d'alimentation haute tension (PS) à un conducteur haute tension du câble d'alimentation (PC) devant être soumis à un essai à un premier emplacement de deux emplacements de mesure sélectionnés le long du câble d'alimentation (PC), la connexion à chacun des deux emplacements de mesure le long du câble d'alimentation (PC) d'un condensateur (Ck) à un conducteur haute tension (C) du câble d'alimentation (PC), **caractérisé par**
- la connexion à l'extrémité basse tension de chaque condensateur (Ck) d'un dispositif de couplage de communication (CCD) et d'un dispositif de couplage de mesure (CD), où le dispositif de couplage de communication (CCD) et le dispositif de couplage de mesure (CD) sont connectés en série,
- la connexion à chaque emplacement de mesure d'un système de communication (CS) au dispositif de couplage de communication (CCD) et la connexion d'un instrument de mesure (MI) au dispositif de couplage de mesure (CD),
- la fourniture de signaux haute tension au conducteur porteur de haute tension (C) du câble d'alimentation (PC) au moyen du bloc d'alimentation haute tension (PS),
- la réception d'un signal de décharge partielle à chacun des deux emplacements de mesure au moyen des instruments de mesure (MI) et la génération de résultats de mesure de la décharge partielle à chaque emplacement de mesure,
- la transmission de résultats de mesure d'une décharge partielle d'un emplacement de mesure via le conducteur haute tension (C) du câble (PC) à l'autre emplacement de mesure,
- la réception des résultats de mesure transmis d'une décharge partielle à l'autre emplacement de mesure.

2. Procédé selon la revendication 1, **caractérisé par**
- le calcul de l'emplacement de la décharge partielle à l'aide des résultats de mesure depuis les deux emplacements de mesure.

3. Procédé selon la revendication 1, **caractérisé par**
la saisie de paramètres de mesure via une interface utilisateur (UI) connectée au système de communication (CS).

4. Procédé selon la revendication 1, **caractérisé par**
la saisie de paramètres de mesure via un dispositif de mesure et de commande automatisé connecté au système de communication (CS).

5. Utilisation du procédé selon l'une des revendications 1 à 4 pour une mesure de décharge partielle sur un système de câble d'alimentation dérivé, où un condensateur (Ck), un dispositif de couplage de communication (CCD), un système de communication (CS) et des instruments de mesure (MI) sont connectés au conducteur du câble à plus de deux emplacements de mesure.

6. Utilisation du procédé selon l'une des revendications 1 à 4 pour soumettre à essai un câble d'alimentation ayant des joints de connexion, où le condensateur (Ck, des dispositifs de couplage de communication (CCD), un système de communication (CS), un dispositif de couplage de mesure (CD) et des instruments de mesure (MI) sont connectés au câble à plusieurs emplacements de joint de connexion.

7. Système configuré pour réaliser le procédé selon la revendication 1 pour soumettre à essai un câble d'alimentation électrique (PC) comprenant
- un bloc d'alimentation haute tension (PS) pouvant être connecté à un conducteur haute tension (C) du câble d'alimentation (PC),
- deux modules d'essai (M1, M2) configurés pour être connectés au conducteur haute tension (C) du câble d'alimentation (PC) en deux points de mesure sélectionnés sur le câble d'alimentation (PC),
chaque module d'essai (M1, M2) contenant :
- un condensateur haute tension (Ck), pouvant être connecté au conducteur haute tension (C) du câble d'alimentation (PC) en les deux points de mesure sur le câble d'alimentation (PC),
**caractérisé par**
- un dispositif de couplage de communication (CCD) connecté à l'extrémité basse tension du condensateur (Ck) et
- un dispositif de couplage de mesure (CD) connecté au dispositif de couplage de communication (CCD) et
- un instrument de mesure (MI) connecté au dispositif de couplage de mesure (CD) et
- un système de communication (CS) connecté au dispositif de couplage de communication (CCD) et à l'instrument de mesure (MI).

8. Système configuré pour réaliser le procédé selon la revendication 1 pour soumettre à essai un câble d'alimentation électrique (PC) comprenant
- un bloc d'alimentation haute tension (PS) pouvant être connecté à un conducteur haute tension (C) du câble d'alimentation (PC),
- deux modules d'essai (Ml', M2') configurés pour être connectés au conducteur haute tension (C) du câble d'alimentation (PC) en deux points de mesure sélectionnés sur le câble d'alimentation (PC),
chaque module d'essai (M1', M2') contenant :
- un condensateur haute tension (Ck), pouvant être connecté au conducteur haute tension (C) du câble d'alimentation (PC) en les deux points de mesure sur le câble d'alimentation (PC),
**caractérisé par**
- un dispositif de couplage de mesure (CD) connecté à l'extrémité basse tension du condensateur (Ck) et
- un dispositif de couplage de communication (CCD) connecté au dispositif de couplage de mesure (CD) et
- un instrument de mesure (MI) connecté au dispositif de couplage de mesure (CD) et
- un système de communication (CS) connecté au dispositif de couplage de communication (CCD) et à l'instrument de mesure (MI).

9. Système selon la revendication 7 ou 8, **caractérisé en ce que**
le dispositif de couplage de communication (CCD) est matérialisé par un couplage galvanique, inductif ou capacitif ou par un commutateur.

10. Système selon la revendication 7 ou 8, **caractérisé en ce que**
le dispositif de couplage de communication (CCD) comprend un commutateur, un transformateur, un résistor, ou un condensateur.

11. Système selon l'une des revendications 7 à 10, **caractérisé en ce que**
une bobine d'induction (Lr) est agencée entre le dispositif de couplage de communication (CCD) et le système de communication (CS).
